(19) Europäisches Patentamt
European Patent Office
Office européen des brevets

(11) **EP 3 225 086 B1**

(12) **EUROPÄISCHE PATENTSCHRIFT**

(45) Veröffentlichungstag und Bekanntmachung des Hinweises auf die Patenterteilung:
**19.02.2020 Patentblatt 2020/08**

(21) Anmeldenummer: **15797662.2**

(22) Anmeldetag: **19.11.2015**

(51) Int Cl.:
*H05K 13/08* (2006.01)     *G06Q 10/06* (2012.01)

(86) Internationale Anmeldenummer:
**PCT/EP2015/077065**

(87) Internationale Veröffentlichungsnummer:
**WO 2016/113021 (21.07.2016 Gazette 2016/29)**

(54) **VERFAHREN UND STEUEREINRICHTUNG ZUR BESTÜCKUNG VON LEITERPLATTEN**

METHOD AND CONTROL SYSTEM FOR POPULATING PRINTED CIRCUIT BOARDS

PROCÉDÉ ET INSTALLATION D'UN SYSTÈME DE CONTROLE POUR ÉQUIPER DES CARTES DE CIRCUITS IMPRIMÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.01.2015 DE 102015200420**

(43) Veröffentlichungstag der Anmeldung:
**04.10.2017 Patentblatt 2017/40**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
**EP-A1- 0 478 360     DE-T2- 69 028 612**

**Beschreibung**

Die vorliegende Erfindung betrifft ein Verfahren und ein System zur Bestückung von Leiterplatten. Dabei wird eine Bestückungslinie vorausgesetzt, die dazu eingerichtet ist, Leiterplatten mit Bauelementen zu bestücken.

Eine elektronische Baugruppe umfasst eine Leiterplatte und Bauelemente, die auf ihr mechanisch und elektrisch befestigt sind. Zur Herstellung der Leiterplatte werden die Bauelemente mittels eines Bestückungsautomaten (pick-and-place) auf der Leiterplatte abgelegt und anschließend in einem Reflow-Ofen mit ihr verlötet. Mehrere Bestückungsautomaten können auf einer Bestückungslinie nacheinander durchlaufen werden. Zur Herstellung vieler Leiterplatten kann ein Bestückungssystem verwendet werden, das mehrere Bestückungslinien umfasst.

Eine Zusammensetzung von Bauelementetypen am Bestückungsautomat wird Rüstung genannt. Mit einer Rüstung kann eine Menge von unterschiedlichen Leiterplatten gefertigt werden, die Rüstfamilie genannt wird. Üblicherweise sollen jedoch Leiterplatten von mehr unterschiedlichen Leiterplattentypen gefertigt werden, als mittels einer Rüstung möglich ist, sodass die Rüstung während der Produktion geändert werden muss.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementetypen ist jedoch aufwändig. Die Rüstungen werden daher oft in Festrüstungen und Variantenrüstungen unterschieden, wobei ein Festrüstungstisch dazu vorgesehen ist, seine Zusammensetzung von Bauelementetypen über einen vorbestimmten Planungszeitraum zu behalten, während ein Variantenrüsttisch voraussichtlich innerhalb des Planungszeitraums umgerüstet wird.

DE 10 2012 220 904 A1 betrifft ein Verfahren zur Bestimmung einer möglichst vorteilhaften Festrüstung für eine Bestückungslinie.

EP 0 478 360 A1 betrifft ein Verfahren zum Gruppieren von zu bestückenden Leiterplatten, um Umrüstzeiten einer Bestückungsanlage zu minimieren.

DE 690 28 612 T2 schlägt ein iteratives Verfahren zur Steuerung der Abfolge von zu bearbeitenden Objekten in einer flexiblen Fertigungsumgebung vor.

Der Erfindung liegt daher die Aufgabe zu Grunde, ein verbessertes Verfahren, ein Computerprogrammprodukt und ein System zur Bestückung von Leiterplatten anzugeben, die eine effizientere Bestückung einer Bestückungslinie erlaubt. Die Erfindung löst diese Aufgabe mittels der Gegenstände der unabhängigen Ansprüche. Unteransprüche geben bevorzugte Ausführungsformen wieder.

Zum Bestücken von Leiterplatten mittels einer Bestückungslinie sind Rüstfamilien mit zugehörigen Rüstungen vorgesehen sind. Jeder Rüstfamilie ist wenigstens ein Leiterplattentyp und jeder Rüstung wenigstens ein Bauelementetyp zugeordnet, sodass eine Leiterplatte eines Leiterplattentyps einer Rüstfamilie mittels Bauelementen der Bauelementetypen der dem Leiterplattentyp zugeordneten Rüstung an der Bestücklinie bestückt werden kann. Dabei kann eine Rüstung in Form von Vorräten von Bauelementen der Bauelementtypen realisiert werden, um an der Bestückungslinie angebracht zu werden. Ein Verfahren zum Bestücken von Leiterplatten umfasst Schritte des Erfassens von Aufträgen, jeweils zur Bestückung von Leiterplatten eines Leiterplattentyps auf der Bestückungslinie, und zugeordneten Wahrscheinlichkeiten, mit denen ein Auftrag jeweils auszuführen ist, des, des Zuordnens von Leiterplattentypen der Aufträge zu Rüstfamilien, des Bestimmens, für jede Rüstfamilie, einer Kennzahl, die die Summe der Wahrscheinlichkeiten derjenigen Aufträge umfasst, deren Leiterplattentypen von der Rüstfamilie umfasst sind, des Optimierens der Zuordnung derart, dass die Kennzahlen unterschiedlicher Rüstfamilien möglichst unterschiedlich sind, des Bereitstellens einer Rüstung einer der bestimmten Rüstfamilien an der Bestückungslinie und des Bestückens von Leiterplatten auf der Bestückungslinie.

Die Aufträge können einen praktisch beliebigen Zeitraum in der Zukunft betreffen. Dabei ist üblicherweise nicht - oder nicht genau - bekannt, wann ein Auftrag tatsächlich vorliegt, also wann der Auftrag auszuführen ist. Der Betrieb der Bestückungslinie folgt üblicherweise einem vorbestimmten Turnus, wobei jeweils für einen kommenden Zeitraum bekannt ist, welche Aufträge zu bearbeiten sind. Die Wahrscheinlichkeit des Auftrags gibt an, wie wahrscheinlich ein Auftrag in einem beliebigen Zeitraum ausgeführt werden muss.

Durch das Verfahren kann beim Bilden der Rüstfamilien bzw. Rüstungen von der Kenntnis Gebrauch gemacht werden, dass bestimmte Leiterplattentypen regelmäßig wieder bestückt werden sollen. Die Rüstungen können so verbessert derart bestimmt werden, dass Rüstwechsel in der laufenden Produktion verringert werden. Eine Anzahl von zu erstellenden Rüstungen kann so verringert sein. Bevorzugterweise werden mittels des Verfahrens Festrüstungen bestimmt, die innerhalb eines langfristigen Planungszeitraums, der beispielsweise mehrere Tage oder Wochen betragen kann, mehrfach an der Bestückungslinie angebracht werden können. Aufträge, die zu dem Zeitpunkt, zu dem das Verfahren durchgeführt wird, noch nicht bekannt sind, können mittels Variantenrüstungen bearbeitet werden, die nur einmal aufgerüstet, dann einmalig an der Bestückungslinie eingesetzt und anschließend wieder abgerüstet werden. Auch von den vorliegenden Aufträgen müssen nicht alle bei der Bestimmung der Festrüstungen berücksichtigt werden, wie unten noch ausgeführt wird, können insbesondere die Aufträge mit den kleinsten Wahrscheinlichkeiten bei der Festrüstungsbildung auch vernachlässigt werden.

Bevorzugterweise wird das Optimieren derart durchgeführt, dass die Anzahl der Rüstfamilien minimiert ist. Eine Anzahl von Rüstungen kann dadurch ebenfalls verringert sein, wodurch sich Handhabungs- und Kostenvorteile ergeben können.

Das Verfahren kann bezüglich eines vorbestimmten Zeitraums durchgeführt werden, wobei die Bearbeitungszeit für einen Auftrag nicht länger als der Zeitraum ist. Insbesondere können sich die Wahrscheinlichkeiten auf das Auftreten eines Auftrags in dem jeweiligen Zeitraum beziehen. Dieser Zeitraum wird auch kurzfristiger Planungshorizont genannt und kann beispielsweise einen Tag betragen. Anders ausgedrückt wird bevorzugterweise davon ausgegangen, dass jeder Auftrag vollständig bearbeitet werden kann, bevor der Zeitraum abgelaufen ist. Üblicherweise sind für jeden Zeitraum vorbestimmte Aufträge vorgegeben, die abzuarbeiten sind.

Die Wahrscheinlichkeiten können auf der Basis vergangener Aufträge bestimmt werden. Beispielsweise können Erfahrungen aus zurückliegenden Produktionszeiträumen vorteilhaft genutzt werden. Insbesondere können Häufigkeiten zurückliegender Aufträge bekannt sein und aus ihnen die Wahrscheinlichkeiten bestimmt werden. Alternativ oder zusätzlich können auch Kenntnisse über kommende Aufträge genutzt werden. In einer realen Fertigung können beispielsweise turnusmäßig bestimmte Aufträge vorliegen.

In einer ersten Variante werden die Rüstfamilien einzeln nacheinander gebildet, wobei das Optimieren jeweils derart durchgeführt wird, dass eine Anzahl von Aufträgen, die mit Rüstungen der Rüstfamilien bearbeitet werden können, maximiert ist.

In einer zweiten Variante werden die Rüstfamilien einzeln nacheinander gebildet und das Optimieren wird jeweils derart durchgeführt, dass für die einer neuen Rüstfamilie zugeordneten Leiterplattentypen folgende Kennzahl minimiert wird: $\log(1-p_r)$; wobei $p_r$ die Wahrscheinlichkeit des Vorliegens eines Auftrags zur Bestückung von Leiterplatten des Leiterplattentyps r ist. Die Wahrscheinlichkeit bezieht sich dabei üblicherweise auf den vorbestimmten Zeitraum, also den kurzfristigen Planungshorizont.

Das Optimieren erfolgt bevorzugt mittels Gemischt Ganzzahliger Optimierung. Dadurch kann in relativ kurzer Bearbeitungszeit eine gute Optimierung erzielt werden; außerdem kann bekannt sein, wie gut die Optimierung von einer besten möglichen Lösung entfernt ist ("Gap").

Ein Computerprogrammprodukt umfasst Programmcodemitteln zur Durchführung eines Verfahrens nach einem der vorangehenden Ansprüche, wenn das Computerprogrammprodukt auf einer Verarbeitungseinrichtung abläuft oder auf einem computerlesbaren Datenträger gespeichert ist.

Eine Steuereinrichtung ist dazu eingerichtet, Aufträge, jeweils zur Bestückung von Leiterplatten eines Leiterplattentyps auf der Bestückungslinie, und zugeordnete Wahrscheinlichkeiten, mit denen ein Auftrag jeweils auszuführen ist, zu erfassen, Leiterplattentypen der Aufträge zu Rüstfamilien zuzuordnen, für jede Rüstfamilie eine Kennzahl zu bestimmen, die die Summe von Wahrscheinlichkeiten derjenigen Aufträge umfasst, deren Leiterplattentypen von der Rüstfamilie umfasst sind, die Zuordnung derart zu optimieren, dass die Kennzahlen unterschiedlicher Rüstfamilien möglichst unterschiedlich sind, und das Bestücken von Leiterplatten auf der Bestückungslinie zu steuern, wenn eine Rüstung einer der bestimmten Rüstfamilien an der Bestückungslinie angebracht ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1    ein Bestückungssystem;

Fig. 2    eine Veranschaulichung von Rüstfamilien an einer Bestückungslinie von Fig. 1;

Fign. 3-5    Auftragszahlen für verschiedene Rüstfamilien in unterschiedlichen Beispielen;

Fig. 6    ein Ablaufdiagramm für ein Verfahren zur Bildung von Festrüstungen für ein Bestückungssystem entsprechend dem von Fig. 1

darstellt.

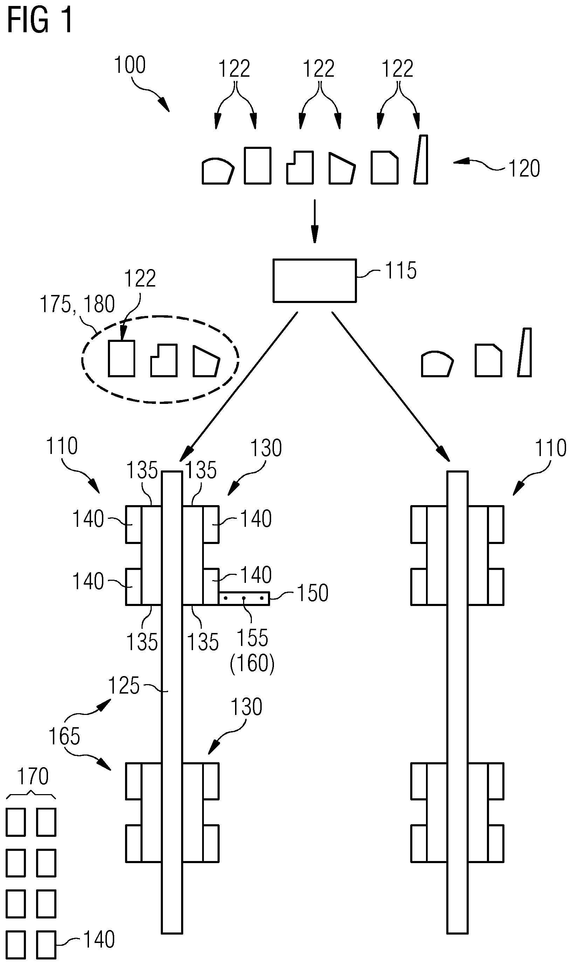

Figur 1 zeigt ein beispielhaftes Bestückungssystem 100. Das Bestückungssystem 100 umfasst eine oder mehrere Bestückungslinien 110 und eine Verarbeitungs- oder Steuereinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente 155 aufzunehmen und an einer vorbestimmten Position auf der Leiterplatte 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementetyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementetyps 160 sind üblicherweise bereitgestellt in einem Gurt, auf einem Tablett oder in einer Röhre. Jeder Bauelementetyp 160 erfordert an der Zuführungseinrichtung 150 und am Rüsttisch 140 eine vorbestimmte Anzahl Spuren, die üblicherweise aneinander angrenzen.

Gewöhnlich kann eine Zuführungseinrichtung 150 zur Bereithaltung von Bauelementen 155 unterschiedlicher Bauelementetypen 160 konfiguriert werden und üblicherweise können unterschiedliche Zuführungseinrichtungen 150 an einem Rüsttisch 140 angebracht werden. Vorliegend wird vereinfachend davon ausgegangen, dass ein Vorrat von Bauelementen 155 eines Bauelementetyps 160 an einer Zuführungseinrichtung 150 praktisch unendlich groß ist, ein Nachrüsten also nicht erforderlich ist.

Wird am Bestückungsautomaten 130 ein Bauelement 155 eines Bauelementetyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht. Das Bestücken eines nicht an der Bestückungslinie 110 angebrachten Rüsttischs 140 mit Bauelementen 155 wird Vorrüstung genannt und kann eine Bearbeitungszeit im Bereich von einer oder mehreren Stunden, beispielsweise ca. 6-10 Stunden, erfordern.

Da ein Wechsel von Rüsttischen 140 an der Bestückungslinie 110, ein so genannter Rüstwechsel, üblicherweise mit einem Produktionsstillstand verbunden ist, wird angestrebt, Wechsel der Rüsttische 140 möglichst selten durchzuführen. Da ferner die Rüsttische 140 kostspielig sind und das Umrüsten eines Rüsttischs 140 aufwändig und langwierig sein kann, wird weiter versucht, möglichst wenige Rüstungen zu bilden, um eine vorbestimmte Produktionsmenge von Leiterplatten 120 vorbestimmter Leiterplattentypen 122 zu fertigen. Die Produktionsmenge umfasst hier mehrere Leiterplattentypen 122, von denen jeweils eine vorbestimmte Stückzahl Leiterplatten 120 mit Bauelementen 155 vorbestimmter Bauelementetypen 160 bestückt werden soll. Beispielsweise können 300 Leiterplatten 120 eines ersten Leiterplattentyps 122 und 200 Leiterplatten 120 eines zweiten Leiterplattentyps 122 bestückt werden.

Eine Rüstung 165, 170 umfasst eine Menge von Bauelementetypen 160 und wird realisiert durch einen oder mehrere Rüsttische 140, die mit Vorräten von Bauelementen 155 der Bauelementetypen 160 der Rüstung 165, 170 ausgestattet und an der Bestückungslinie 110 angebracht sind.

Der Rüstung 165, 170 ist eine Rüstfamilie 175 zugeordnet, die Leiterplattentypen 122 umfasst, von denen Leiterplatten 120 mittels Bauelementen 155 der Bauelementetypen 160 der Rüstung 165, 170 bestückt werden können. Eine Rüstfamilie 175 ist genau einer Rüstung 165, 170 zugeordnet und umgekehrt.

Um die Auslastung einer Bestückungslinie 110 zu erhöhen oder einen Bedarf an Rüsttischen 140 zu verringern ist es daher entscheidend, wie auf der Basis der zu bestückenden Leiterplattentypen 122 Rüstfamilien 175 gebildet werden. Bei der Bildung von Rüstungen 165, 170 bzw. Rüstfamilien 175 können Nebenbedingungen zu beachten sein, beispielsweise die Einhaltung einer begrenzten Fassungskapazität eines Rüsttisches 140 für Bauelementtypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Rüstungen können in Festrüstungen 165 und Variantenrüstungen 170 unterschieden werden, wobei eine Festrüstung 165 dazu vorgesehen ist, auf einer Anzahl Wechseltische 140 über einen vorbestimmten Planungszeitraum unverändert gerüstet zu bleiben, während ein Wechseltisch 140 einer Variantenrüstung 170 voraussichtlich innerhalb des Planungszeitraums mit Bauelementen 155 anderer Bauelementetypen 160 umgerüstet wird. Der Planungszeitraum kann beispielsweise 6 bis 12 Monate betragen. Eine Variantenrüstung 165 besteht in einer vorbestimmten Konstellation üblicherweise wesentlich kürzer als der Planungszeitraum, beispielsweise über mehrere Stunden oder Tage, üblicherweise jedoch nicht über mehr als eine Woche.

Es kann auch eine statische Rüstung gebildet werden, die Elemente der Festrüstung 165 und der Variantenrüstung 170 trägt. Die statische Rüstung wird wie die Festrüstung 165 für einen längeren Zeitraum gebildet, über den sie üblicherweise unverändert bleibt. Die statische Rüstung bleibt jedoch üblicherweise nicht aufgerüstet, also als Rüstung physisch auf Rüsttischen 140 realisiert, sondern kann nach der Verwendung auch wieder abgerüstet werden. Außerdem kann eine statische Rüstung auch nur partiell gerüstet (=realisiert) werden, wenn beispielsweise die statische Rüstung mehrere Leiterplattentypen 122 umfasst und zu einem Zeitpunkt nur Aufträge zur Fertigung von Leiterplatten 120 einiger dieser Leiterplattentypen 122 vorliegen. Bauelemente 155 von solchen Bauelementtypen 160, die zur Bestückung der beauftragten Leiterplatten 120 nicht erforderlich sind, können dann nicht aufgerüstet werden.

Die statische Rüstung ist verwaltungstechnisch häufig leichter zu handhaben als eine Festrüstung 165 oder eine Variantenrüstung 170. Wird die statische Rüstung nach ihrer Verwendung nicht abgerüstet, kann auch von einer Festrüstung 165 gesprochen werden. Im Folgenden sind, wo nicht anders angegeben, bevorzugterweise statische Rüstfamilien und die ihnen zugeordneten statischen Rüstungen gemeint.

Die Rüstungen 165, 170 können nach Bedarf an der Bestückungslinie 110 ausgetauscht werden. Um eine Festrüstung 165 oder eine Variantenrüstung 170 zu realisieren wird üblicherweise ein Rüsttisch 140, während er nicht an der Bestückungslinie 110 angebracht ist, mit Vorräten von Bauelementen 155 vorbestimmter Bauelementetypen 160 aufgerüstet. Bereits aufgerüstete Bauelemente 155 nicht benötigter Bauelementetypen 160 können zuvor abgerüstet werden. Diese Umrüstung kann einen erheblichen Anteil manueller Arbeit umfassen und zeitaufwändig sein.

Um den mit einer Variantenrüstung 170 verbundenen Aufwand zu minimieren wird versucht in den Festrüstungen 165 möglichst viele Leiterplattentypen 122 aufzunehmen. Ein angestrebter Fall ohne Variantenrüstungen 170 ist in der Praxis jedoch kaum erzielbar.

Die Steuereinrichtung 115 ordnet im Rahmen der Steuerung des Bestückungssystems 100 Leiterplattentypen 122, deren zugeordnete Leiterplatten 120 auf der Bestückungslinie 110 bestückt werden sollen, jeweils einer Rüstfamilie 175 zu, wobei Festrüstungs-Rüstfamilien 175, die jeweils einer Festrüstung 165 zugeordnet ist, und Variantenrüstungs-Rüstfamilien 175, die jeweils einer Variantenrüstung 170 zugeordnet sind, gebildet werden können.

In der Praxis kann beispielsweise für eine vorgegebene Produktionsmenge von Leiterplattentypen 122 in einem ersten Schritt eine Festrüstung 165 für einen (möglichst großen) Teil der Leiterplattentypen 122 gebildet werden, worauf in einem zweiten Schritt für den verbleibenden Teil der Leiterplattentypen 122 Variantenrüstungen 170 gebildet werden. Die Qualität dieser Zuordnungen entscheidet in hohem Maß darüber, wie gut die Produktionsmittel des Bestückungssystems 100 ausgelastet werden können und wie effizient dabei bestückt werden kann.

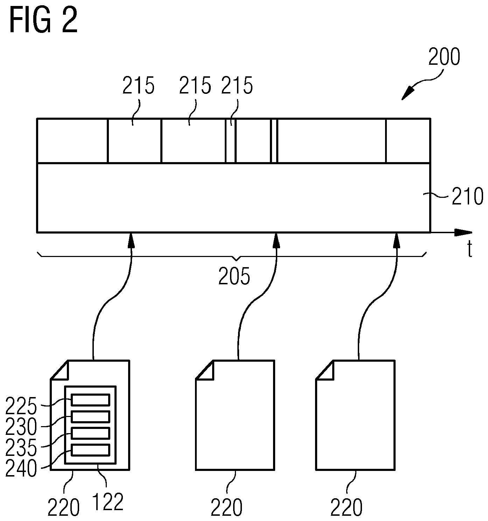

Figur 2 zeigt eine Veranschaulichung beispielhafter Rüstfamilien 175 an einer Bestückungslinie 110 aus Figur 1. Die Rüstfamilien 175 werden hier in eine Festrüstungs-Rüstfamilie 210, die einer Festrüstung 165 zugeordnet ist, und eine Variantenfertigungs-Rüstfamilie 215, die einer Variantenrüstung 170 zugeordnet ist, unterschieden. Innerhalb eines Planungszeitraums 205 können an der Bestückungslinie 110 im dargestellten Beispiel Leiterplattentypen 122 einer einzigen Festrüstungs-Rüstfamilie 210 oder einer einzigen Variantenfertigungs-Rüstfamilie 215 bestückt werden.

Es wird davon ausgegangen, dass zu Beginn des Planungszeitraums 205 mehrere Aufträge 220 vorliegen, die möglichst effizient auszuführen sind. Die Zahl der Aufträge wird Auftragszahl genannt. Jeder Auftrag 220 umfasst wenigstens einen Leiterplattentyp 122 und eine Stückzahl 225 zu bestückender Leiterplatten 120. Dem Leiterplattentyp 122 sind Bauelementetypen 160 zugeordnet, von denen Bauelemente 155 auf den einzelnen Leiterplatten 120 zu bestücken sind.

Einem Leiterplattentyp 122 können weitere Informationen zugeordnet sein. Beispielsweise können eine Anzahl 230 von Bauelementetypen 160, die auf jeder Leiterplatte 120 bestückt werden sollen, eine Anzahl 235 von Bestückpositionen einer Leiterplatte 120 oder eine Produktionszeit 240 für eine Leiterplatte 120, jeweils des Leiterplattentyps 122, angegeben sein. Die Anzahl der Bestückpositionen entspricht der Anzahl der auf einer Leiterplatte 120 des Leiterplattentyps 122 zu bestückenden Bauelemente 155, gleich welchen Bauelementetyps 160. Ferner kann eine Auftragszahl 245 angegeben sein, die angibt, wie viele Aufträge 220 zur Bestückung von Leiterplatten 120 eines Leiterplattentyps 122 in einem vorbestimmten Planungszeitraum 205 vorliegen.

Durch den Einsatz von mathematischen Verfahren lassen sich für die Zuordnung von Leiterplattentypen 122 zu Festrüstungs-Rüstfamilien 175 bzw. zu Bestückungslinien 110 deutlich bessere Lösungen erzielen als mit bisher in der Praxis verwendeten Vorgehensweisen. Zur Bestimmung einer optimierten Zuordnung von Leiterplattentypen 122 zu einer Festrüstungs-Rüstfamilie 175 kann eine automatische Optimierung verwendet werden. Dabei können unterschiedliche Optimierungsverfahren verwendet werden, beispielsweise auf der Basis von lokalen Suchverfahren oder metaheuristischen Algorithmen.

Bevorzugterweise wird jedoch ein IP-Modell (Integer Programmierung bzw. Integer Programm oder Gemischt Ganzzahliges Optimierungsmodell) verwendet. Eines der Hauptverfahren auf dem Gebiet der mathematischen Optimierung ist die Lineare Optimierung, die sich mit der Optimierung linearer Zielfunktionen über einer Menge befasst, die durch lineare Gleichungen und Ungleichungen eingeschränkt ist. Die Lineare Optimierung ist die Grundlage der Lösungsverfahren der (Gemischt) Ganzzahligen Linearen Optimierung.

Vorteile der Linearen Optimierung:

- Globaler Optimierungsansatz
- Leicht erweiterbar
- Sehr gute kommerzielle Standard-Solver (Ilog, Gurobi, Xpress), die in der Praxis weit verbreitet und bewährt sind
- Für eine ermittelte Lösung ist bekannt, wie weit sie maximal von der optimalen Lösung entfernt ist (Gap).

Im Folgenden werden Beispiele für IP-Formulierungen zur Optimierung der beschriebenen Zuordnung von Leiterplattentypen 122 zu einer Festrüstungs-Rüstfamilie 175 gegeben.

Es wird ausgegangen von einem kurzfristigen Planungszeitraum $T_K$, der beispielsweise mehrere Stunden oder Tage betragen kann, und einem langfristigen Planungszeitraum $T_L$, der mehrfach länger als $T_K$ ist, beispielsweise mehrere Tage, Wochen oder Monate. Es sollen Festrüstungen für die Bestückungslinie 110 bestimmt werden, die über den langfristigen Planungszeitraum $T_L$ unverändert bleiben und mehrfach eingesetzt werden können. Die Bestimmung soll so erfolgen, dass im Betrieb der Bestückungsanlage 110 möglichst wenige Rüstwechsel und möglichst wenige Rüstungen erforderlich sind. Dazu soll ausgenutzt werden, dass zum Zeitpunkt der Bestimmung der Festrüstungen schon einige Informationen über kommende Aufträge bekannt sind.

Im Betrieb der Bestückungslinie 110 ist für den jeweils nächsten kurzfristigen Planungszeitraum bekannt, welche Aufträge zu bearbeiten sind. Für einen Auftrag, der nicht mittels einer der Festrüstungen bearbeitet werden kann, muss eine Variantenrüstung erstellt werden. Die Qualität der eingangs getroffenen Zuordnung von Leiterplattentypen zu Festrüstungs-Rüstfamilien ist daher entscheidend dafür, wie häufig Rüstwechsel erfolgen und wie häufig Variantenrüstungen erstellt werden müssen.

Bezeichnungen

R        Menge der Leiterplattentypen
CI       Menge von Rüstfamilien, bestehend aus allen Leiterplattentypen aus R
$Order_r$   Anzahl Aufträge für den Leiterplattentyp r im langfristigen Planungszeitraum
$T_L$      Anzahl der Tage im langfristigen Planungszeitraum
$T_K$      Anzahl der Tage im kurzfristigen Planungszeitraum

Bewertungsmodell

Es gelte, dass $Order_r \leq T_L/T_K$. Diese Bedingung kann gegebenenfalls dadurch erfüllt werden, dass $Order_r :=$ $T_L/T_K$ gesetzt wird.

$p_r$ sei die Wahrscheinlichkeit, mit der im kurzfristigen Planungszeitraum $T_K$ ein Auftrag zur Bestückung einer Leiterplatte 120 des Leiterplattentyps 122 auszuführen ist, beispielsweise 0,08. Die Wahrscheinlichkeit $p_r$ entspricht den relativen Häufigkeit, mit der derartige Aufträge durchschnittlich auftreten, in obigem Beispiel etwa, wenn 8 derartige Aufträge auf 100 kurzfristige Planungszeiträume $T_K$ kommen. Diese Häufigkeit kann beispielsweise anhand vergangener Planungszeiträume $T_K$ oder aus der Kenntnis kommender Aufträge bestimmt werden.

Es wird angenommen, dass sich die Aufträge jeweils gleichmäßig auf die kurzfristigen Planungszeiträume $T_K$ verteilen.

$$p_r = \frac{T_K Order_r}{T_L}$$

Es wird ferner angenommen, dass die Aufträge voneinander unabhängig sind. Innerhalb des kurzfristigen Planungszeitraums $T_K$ können alle vorliegenden Aufträge mittels der Festrüstung und einer oder mehreren Variantenrüstungen bearbeitet werden. Dazu wird jede im kurzfristigen Planungszeitraum $T_K$ erforderliche Variantenrüstung nur einmal aufgerüstet, dann werden damit alle zu fertigenden Leiterplatten der zugeordneten Leiterplattentypen bestückt und anschließend wird die Variantenrüstung wieder abgerüstet. Eine erneute Verwendung der Variantenrüstung an der Bestückungslinie 110 ist nicht vorgesehen.

Der Erwartungswert dafür, dass eine Rüstfamilie $cl \in CI$ im kurzfristigen Planungszeitraum an der Bestückungslinie 110 gerüstet werden muss, ergibt sich wie folgt:

```
EW(cl)      = Wahrscheinlichkeit, dass mindestens eine Baugruppe
              r ∈ cl gefertigt werden muss

            = 1 - Wahrscheinlichkeit, dass keine Baugruppe r ∈
              cl gefertigt werden muss
```

$$= 1 - \prod_{r \in cl}(1 - p_r)$$

Als Erwartungswert "EW(Anzahl)" für die Anzahl der zu rüstenden Rüstfamilien in einem kurzfristigen Planungszeitraum ergibt sich damit:

$$EW(Anzahl) = \sum_{cl \in Cl} 1 - \prod_{r \in cl}(1 - p_r)$$

$$= Anzahl\ R\ddot{u}stfamilien - \sum_{cl \in Cl}\prod_{r \in cl}(1 - p_r)$$

Dieser Erwartungswert ist ein gutes Gütekriterium für eine Menge von Festrüstungs-Rüstfamilien Cl.

Beispiele

Der langfristige Planungszeitraum betrage in den folgenden Beispielen 100 Tage und der kurzfristige Planungszeitraum 1 Tag. Es wird gezeigt, dass hinsichtlich der Orderzahl unausgeglichene Festrüstungs-Rüstfamilien tendenziell besser sind als ausgeglichene Festrüstungs-Rüstfamilien.
Die Baugruppen und deren Auftragszahlen sind wie folgt gegeben:

| Baugruppe | r1 | r2 | r3 | r4 | r5 | r6 |
|---|---|---|---|---|---|---|
| Anzahl Aufträge | 90 | 70 | 50 | 50 | 30 | 10 |
| pr | 0,9 | 0,7 | 0,5 | 0,5 | 0,3 | 0,1 |

Es wird angenommen, dass die Rüstungen, beispielsweise über die Kapazitäten der Rüsttische, darauf beschränkt sind, jeweils nur Bauelemente von Bauelementetypen zweier Leiterplattentypen aufzunehmen, sodass eine Rüstfamilie nur zwei Leiterplattentypen aufnehmen kann.

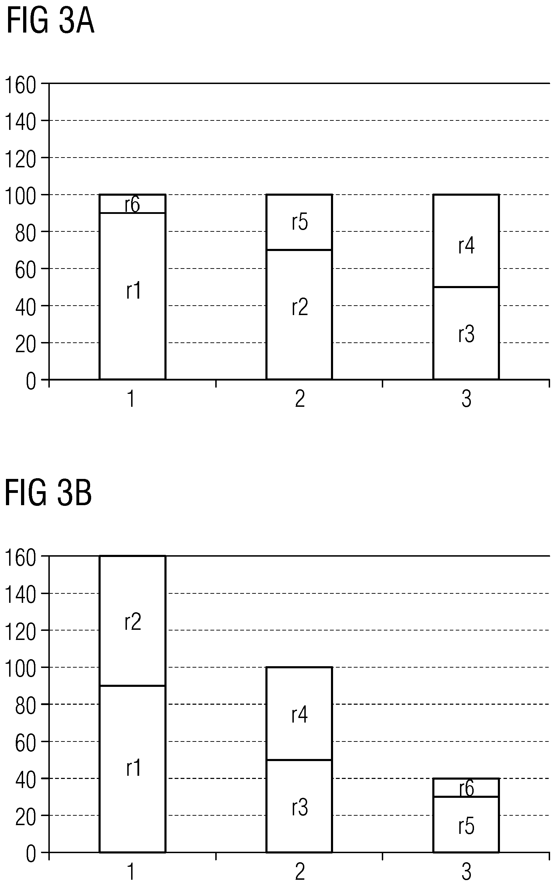

Figur 3a zeigt ausgeglichene Rüstfamilien hinsichtlich der absoluten Auftragshäufigkeiten. In einer vertikalen Richtung ist eine Anzahl Aufträge und in einer horizontalen Richtung sind unterschiedliche Rüstfamilien dargestellt. Mit der ersten Rüstfamilie können die Aufträge r1, mit der zweiten die Aufträge r2 und r5 und mit der dritten die Aufträge r3 und r4 bearbeitet werden.
Der Erwartungswert EW für die Anzahl der Rüstungen im kurzfristigen Planungszeitraum beträgt:

$$\begin{aligned}
EW &= 3 - (0{,}1 * 0{,}9 + 0{,}3 * 0{,}7 + 0{,}5 * 0{,}5) \\
&= 3 - (0{,}09 + 0{,}21 + 0{,}25) \\
&= 3 - 0{,}55 \\
&= 2{,}45
\end{aligned}$$

Figur 3b zeigt unausgeglichene Rüstfamilien hinsichtlich der absoluten Auftragshäufigkeiten. Der Erwartungswert für die Anzahl der Rüstungen im kurzfristigen Planungszeitraum beträgt jetzt nur noch 2,09 Rüstungen. Es werden also weniger Rüstwechsel erforderlich sein, wodurch die Effizienz der Bestückungslinie 110 gesteigert sein kann.

Bessere Lösung mit einer zusätzlichen Rüstfamilie

Nachfolgend soll gezeigt werden, dass es nicht immer besser ist, die minimale Anzahl an Rüstfamilien anzustreben. Die Baugruppen und die Anzahl korrespondierender Aufträge innerhalb des langen Planungshorizonts sind wie folgt gegeben:

| Baugruppe | r1 | r2 | r3 | r4 | r5 |
|---|---|---|---|---|---|
| Anzahl Aufträge | 90 | 50 | 50 | 10 | 10 |
| pr | 0,9 | 0,5 | 0,5 | 0,1 | 0,1 |

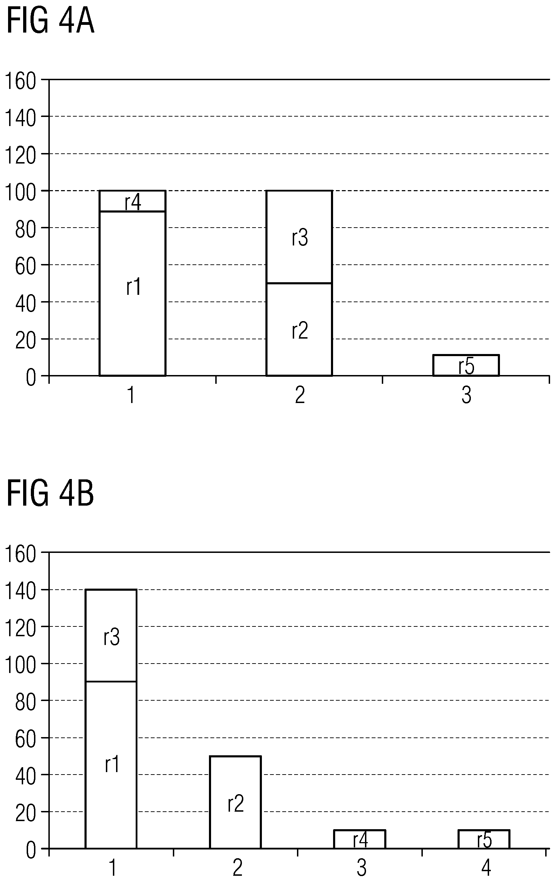

Figur 4a zeigt eine Aufteilung der Aufträge auf drei Rüstfamilien. Der Erwartungswert für die Anzahl der Rüstungen im kurzfristigen Planungszeitraum beträgt 1,76 Rüstungen.

Figur 4b zeigt eine Aufteilung mit vier Rüstfamilien. Der Erwartungswert für die Anzahl der Rüstungen im kurzfristigen Planungszeitraum beträgt 1,65 Rüstungen:

$$EW = 4 - (0,1 * 0,5 + 0,5 + 0,9 + 0,9)$$
$$= 4 - 2,35$$
$$= 1,65$$

Heuristiken

Das Zuordnungsproblem lässt sich als gemischt ganzzahliges nichtlineares Optimierungsproblem formulieren. Es ist allerdings anzunehmen, dass dieses Problem nur schwer lösbar ist. Deshalb werden im Folgenden verschiedene Heuristiken vorgeschlagen, um das Problem mittels linearer Optimierung zu lösen.

Heuristik 1

Mit dem in der Patentanmeldung DE 10 2012 220 904.2 beschriebenen Verfahren lassen sich Rüstungen mit einer maximalen Anzahl von Aufträgen bilden. Die Heuristik 1 besteht darin, mit Hilfe dieses Verfahrens sukzessive Festrüstungs-Rüstfamilien, jeweils mit einer maximalen Anzahl an Aufträgen, zu bilden. Dadurch werden die Rüstfamilien voll gepackt und es resultiert eine relativ geringe Anzahl an Rüstfamilien. Zudem besitzen die zuletzt gebildeten Rüstfamilien nur sehr wenige Aufträge, die nur wenig die erwartete Anzahl an Rüstungen erhöhen (vgl. obiges Beispiel zu Figuren 3b und 3c)

Heuristik 2

Die Heuristik 2 besteht wie Heuristik 1 darin, mit Hilfe des genannten Verfahrens sukzessive aus der Menge der verbleibenden Baugruppen Rüstfamilien cl zu bilden. Allerdings mit dem Zielkriterium, dass jeweils

$$EW(cl) = 1 - \prod_{r \in cl}(1 - p_r)$$

maximal ist. Dazu ist im Verfahren der Anmeldung DE 10 2012 220 904.2 die Zielfunktion im MIP wie folgt abzuändern.
Mit R' wird die Menge der restlichen, sich noch nicht in Festrüstungs-Rüstungen befindlichen Baugruppen bezeichnet. Es wird zudem angenommen, dass gilt $p_r < 1$ für alle $r \in R'$. Es wird nur eine Festrüstungsfamilie/ statische Rüstfamilie cl gebildet. Weiterhin gilt folgende Bezeichnung aus dem MIP:
$Assign_{r,cl}$: Variable, die angibt, ob eine Leiterplatte r zur Festrüstungs-Rüstfamilie cl zugeordnet wird. Besteht eine Zuordnung, nimmt die Variable den Wert 1 an, andernfalls den Wert 0.
Die Zielfunktion max EW(cl) kann als nichtlineare Zielfunktion mit den ganzzahligen Variablen $Assign_{r,cl}$ formuliert werden:

$$maximize \ 1 - \prod_{r \in R'}(1 - p_r)^{Assign_{r,cl}}$$

Diese ist äquivalent mit:

$$minimize \ 1 - \prod_{r \in R'}(1 - p_r)^{Assign_{r,cl}}(*)$$

Weiterhin gilt:

$$\prod_{r \in R'}(1 - p_r)^{Assign_{r,cl}} = e^{log \prod_{r \in R'}(1 - p_r)^{Assign_{r,cl}}}$$

Da die Exponentialfunktion streng monoton steigend ist und es gilt

$$log \prod_{r \in R'} (1 - p_r)^{Assign_{r,cl}} = \sum_{r \in R'} \log(1 - p_r) \, Assign_{r,cl}$$

ist die Zielfunktion (*) äquivalent zu

$$minimize \sum_{r \in R'} \log (1 - p_r) Assign_{r,cl}$$

Diese Zielfunktion ist linear und kann somit im MIP als neue Zielfunktion verwendet werden. In einem Beispiel, in dem Heuristik 2 besser als Heuristik 1 ist, sind folgende Baugruppen und Auftragszahlen gegeben:

| Baugruppe | r1 | r2 | r3 | r4 |
|---|---|---|---|---|
| Anzahl Aufträge | 90 | 50 | 50 | 50 |

Es wird angenommen, dass r1 mit nur einem weiteren Leiterplattentyp in eine Rüstfamilie passt und r2-r4 in eine gemeinsame Rüstfamilie passen.

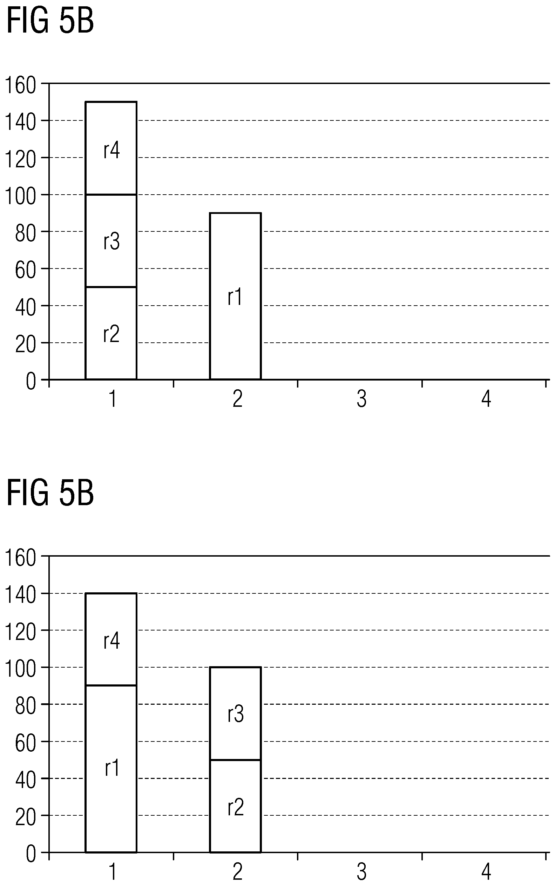

Figur 5a zeigt das Ergebnis der Heuristik 1. Der Erwartungswert für die Anzahl der Rüstungen im kurzfristigen Planungszeitraum beträgt 1,775 Rüstungen.

Figur 5b zeigt das Ergebnis der Heuristik 2. Der Erwartungswert für die Anzahl der Rüstungen im kurzfristigen Planungszeitraum beträgt: 1,7 Rüstungen.

Heuristik 3

Sollte mit den Heuristiken 1 und 2 jeweils die minimale Anzahl an Rüstfamilien überschritten werden, so wird zudem Heuristik 3 vorgeschlagen.

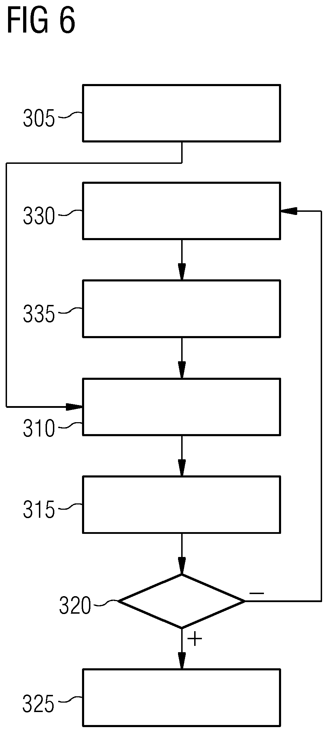

Figur 6 zeigt ein Ablaufdiagramm eines Verfahrens 300 für Heuristik 3. Das Verfahren 300 beginnt in einem Schritt 305, in dem die Menge der noch zuzuordnenden Leiterplattentypen R' gleich der Menge der ursprünglich zuzuordnenden Leiterplattentypen R gesetzt wird. Die aktuelle Rüstfamilie $cl_{opt}$ ist zunächst leer.

Anschließend werden in einem Schritt 310 die verbleibenden Baugruppen aus R' beispielsweise mit einem "Verfahren zur Bildung von Rüstfamilien auf Bestückungslinien" in Rüstfamilien aufgeteilt und man erhält so jeweils in jeder Iteration eine weitere alternative Lösung $Cl_{min}$.

Die Kombination der Lösungen $Cl_{opt}$ und $Cl_{min}$ wird in einem Schritt 315 bezüglich des Erwartungswerts für die Anzahl der Rüstungen im kurzfristigen Planungshorizont bewertet und die beste Lösung wird ausgewählt.

In einem Schritt 320 wird entschieden, ob sich noch Leiterplattentypen in R' befinden. Ist dies nicht der Fall, endet das Verfahren 300 in einem Schritt 325. Andernfalls springt das Verfahren zu einem Schritt 330. Andere oder zusätzliche Abbruchkriterien, sind ebenfalls möglich, etwa das Erreichen einer maximalen Ausführungszeit oder das Bilden einer vorbestimmten Anzahl Festrüstungen.

Im Schritt 330 wird dann wieder wie in den Heuristiken 1 und 2 beispielsweise mit dem in DE 10 2012 220 904.2 beschriebenen Verfahren sukzessive bezüglich einer maximalen Auftragszahl bzw. einem maximalen Erwartungswert eine Rüstfamilie $cl_{opt}$ erstellt.

In einem nachfolgenden Schritt 325 wird $cl_{opt}$ der Rüstfamilienmenge $Cl_{opt}$ hinzugefügt. Die Leiterplatten von $cl_{opt}$ werden aus R' gelöscht. Anschließend fährt das Verfahren 300 mit dem oben beschriebenen Schritt 310 fort.

Obwohl die Erfindung im Detail durch das bevorzugte Ausführungsbeispiel näher illustriert und beschrieben wurde, ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren (300) zum Bestücken von Leiterplatten (120)

   - mittels einer Bestückungslinie (110),
   - wobei Rüstfamilien (210, 215) mit zugehörigen Rüstungen (165, 170) vorgesehen sind;
   - wobei jeder Rüstfamilie (210, 215) wenigstens ein Leiterplattentyp (122) und jeder Rüstung (165, 170) wenigstens ein Bauelementetyp (160) zugeordnet ist,

- sodass eine Leiterplatte (120) eines Leiterplattentyps (122) einer Rüstfamilie (210, 215) mittels Bauelementen (155) der Bauelementetypen (160) der dem Leiterplattentyp (122) zugeordneten Rüstung (165, 170) an der Bestücklinie bestückt werden kann;
- wobei eine Rüstung (165, 170) in Form von Vorräten von Bauelementen (150) der Bauelementtypen (160) realisiert werden kann, um an der Bestückungslinie (110) angebracht zu werden,

wobei das Verfahren (300) folgende Schritte umfasst:

- Erfassen von Aufträgen (220), jeweils zur Bestückung von Leiterplatten (120) eines Leiterplattentyps (122) auf der Bestückungslinie (110);
- Erfassen eines vorbestimmten, in der Zukunft liegenden Zeitraums;
- Erfassen von den Aufträgen (220) jeweils zugeordneten Wahrscheinlichkeiten, mit denen der zugeordnete Auftrag (220) im vorbestimmten Zeitraum auszuführen ist;
- wobei der Zeitraum zumindest so lange dauert, dass jeder der erfassten Aufträge (220) innerhalb dieses Zeitraums abgearbeitet werden kann;
- wobei beim Bestimmen der Wahrscheinlichkeiten Häufigkeiten zurückliegender Aufträge (220), Kenntnisse über kommende Aufträge (220) und/oder turnusmäßig auftretende Aufträge (220) berücksichtigt werden;
- Zuordnen von Leiterplattentypen (122) der Aufträge (220) zu Rüstfamilien (210, 215);
- Bestimmen, für jede Rüstfamilie (210, 215), einer Kennzahl, die die Summe der Wahrscheinlichkeiten derjenigen Aufträge (220) umfasst, deren Leiterplattentypen (122) von der Rüstfamilie (210, 215) umfasst sind;
- Optimieren der Zuordnung derart, dass die Kennzahlen unterschiedlicher Rüstfamilien (210, 215) möglichst unterschiedlich sind;
- Bereitstellen einer Rüstung (165, 170) einer der bestimmten Rüstfamilien (210, 215) an der Bestückungslinie (110); und
- Bestücken von Leiterplatten (120) auf der Bestückungslinie (110).

2. Verfahren (300) nach Anspruch 1, wobei das Optimieren derart durchgeführt wird, dass die Anzahl der Rüstfamilien (210, 215) minimiert ist.

3. Verfahren (300) nach einem der vorangehenden Ansprüchen, wobei die Rüstfamilien (210, 215) einzeln nacheinander gebildet werden und das Optimieren jeweils derart durchgeführt wird, dass eine Anzahl von Aufträgen (220), die mit Rüstungen (165, 170) der Rüstfamilien (210, 215) bearbeitet werden können, maximiert ist.

4. Verfahren (300) nach einem der vorangehenden Ansprüchen, wobei die Rüstfamilien (210, 215) einzeln nacheinander gebildet werden und das Optimieren jeweils derart durchgeführt wird, dass für die einer neuen Rüstfamilie (210, 215) zugeordneten Leiterplattentypen (122) folgende Kennzahl minimiert wird: $\log(1-p_r)$; wobei $p_r$ die Wahrscheinlichkeit eines Auftrags (220) zur Bestückung von Leiterplatten (120) des Leiterplattentyps (122) r ist.

5. Verfahren (300) nach einem der vorangehenden Ansprüche, wobei das Optimieren mittels Gemischt Ganzzahliger Optimierung erfolgt.

6. Steuereinrichtung zur Bestückung von Leiterplatten (120) mittels einer Bestückungslinie (110),

- wobei Rüstfamilien (210, 215) mit zugehörigen Rüstungen (165, 170) vorgesehen sind;
- wobei jeder Rüstfamilie (210, 215) wenigstens ein Leiterplattentyp (122) und jeder Rüstung (165, 170) wenigstens ein Bauelementetyp (160) zugeordnet ist,
- sodass eine Leiterplatte (120) eines Leiterplattentyps (122) einer Rüstfamilie (210, 215) mittels Bauelementen (150) der Bauelementetypen (160) der dem Leiterplattentyp (122) zugeordneten Rüstung (165, 170) an der Bestücklinie bestückt werden kann;
- wobei eine Rüstung (165, 170) in Form von Vorräten von Bauelementen (150) der Bauelementtypen (160) realisiert werden kann, um an der Bestückungslinie (110) angebracht zu werden,

wobei die Steuereinrichtung (115) dazu eingerichtet ist,

- Aufträge (220), jeweils zur Bestückung von Leiterplatten (120) eines Leiterplattentyps (122) auf der Bestückungslinie (110) zu erfassen;
- einen vorbestimmten, in der Zukunft liegenden Zeitraum zu erfassen;

- den Aufträgen (220) jeweils zugeordnete Wahrscheinlichkeiten zu erfassen, mit denen der zugeordnete Auftrag (220) im vorbestimmten Zeitraum auszuführen ist;
- wobei der Zeitraum zumindest so lange dauert, dass jeder der erfassten Aufträge (220) innerhalb dieses Zeitraums abgearbeitet werden kann;
- wobei beim Bestimmen der Wahrscheinlichkeiten Häufigkeiten zurückliegender Aufträge (220), Kenntnisse über kommende Aufträge (220) und/oder turnusmäßig auftretende Aufträge (220) berücksichtigt werden;
- Leiterplattentypen (122) der Aufträge (220) zu Rüstfamilien (210, 215) zuzuordnen;
- für jede Rüstfamilie (210, 215) eine Kennzahl zu bestimmen, die die Summe von Wahrscheinlichkeiten derjenigen Aufträge (220) umfasst, deren Leiterplattentypen (122) von der Rüstfamilie (210, 215) umfasst sind;
- die Zuordnung derart zu optimieren, dass die Kennzahlen unterschiedlicher Rüstfamilien (210, 215) möglichst unterschiedlich sind; und
- das Bestücken von Leiterplatten (120) auf der Bestückungslinie (100) zu steuern, wenn eine Rüstung (165, 170) einer der bestimmten Rüstfamilien (210, 215) an der Bestückungslinie (110) angebracht ist.

## Claims

1. Method (300) for populating printed circuit boards (120)

    - by means of a pick-and-place line (110),
    - wherein set-up families (210, 215) having associated set-ups (165, 170) are provided;
    - wherein each set-up family (210, 215) is assigned at least one printed circuit board type (122), and each set-up (165, 170) is assigned at least one component type (160),
    - such that a printed circuit board (120) of a printed circuit board type (122) of a set-up family (210, 215) can be populated by means of components (155) of the component types (160) of the set-up (165, 170) assigned to the printed circuit board type (122) on the pick-and-place line;
    - wherein a set-up (165, 170) can be implemented in the form of supplies of components (150) of the component types (160), in order to be fitted on the pick-and-place line (110),

    wherein the method (300) comprises the following steps:

    - acquiring jobs (220), in each case relating to the population of printed circuit boards (120) of a printed circuit board type (122) on the pick-and-place line (110);
    - acquiring a predetermined future time period;
    - acquiring probabilities, respectively associated with the jobs (220), with which the associated job (220) is to be executed in the predetermined time period;
    - wherein the time period lasts at least long enough that each of the acquired jobs (220) can be processed within said time period;
    - wherein frequencies of previous jobs (220), knowledge of forthcoming jobs (220) and/or jobs (220) arising in a rotation are considered in the determination of the probabilities;
    - assigning printed circuit board types (122) of the jobs (220) to set-up families (210, 215);
    - determining, for each set-up family (210, 215), a characteristic number which comprises the sum of probabilities of those jobs (220), the printed circuit board types (122) of which are comprised by the set-up family (210, 215);
    - optimizing the assignment in such a way that the characteristic numbers of different set-up families (210, 215) are as different as possible;
    - providing a set-up (165, 170) from one of the determined set-up families (210, 215) on the pick-and-place line (110); and
    - populating printed circuit boards (120) on the pick-and-place line (110).

2. Method (300) according to Claim 1, wherein optimization is executed such that the number of set-up families (210, 215) is minimized.

3. Method (300) according to one of the preceding claims, wherein the set-up families (210, 215) are constituted individually in sequence, and optimization is executed in each case such that a number of jobs (220) which can be processed using set-ups (165, 170) from the set-up families (210, 215) is maximized.

4. Method (300) according to one of the preceding claims, wherein the set-up families (210, 215) are constituted individually in sequence, and optimization is executed in each case such that, for the printed circuit board types (122) assigned to a new set-up family (210, 215), the following characteristic number is minimized: log(1 - $p_r$); where $p_r$ is the probability of an occurrence of a job (220) for the population of printed circuit boards (120) of printed circuit board type (122) r.

5. Method (300) according to one of the preceding claims, wherein optimization is executed by means of mixed integer optimization.

6. Control device for populating printed circuit boards (120) by means of a pick-and-place line (110),

- wherein set-up families (210, 215) having associated set-ups (165, 170) are provided;
- wherein each set-up family (210, 215) is assigned at least one printed circuit board type (122), and each set-up (165, 170) is assigned at least one component type (160),
- such that a printed circuit board (120) of a printed circuit board type (122) of a set-up family (210, 215) can be populated by means of components (150) of the component types (160) of the set-up (165, 170) assigned to the printed circuit board type (122) on the pick-and-place line;
- wherein a set-up (165, 170) can be implemented in the form of supplies of components (150) of the component types (160), in order to be fitted on the pick-and-place line (110),

wherein the control device (115) is designed:

- to acquire jobs (220), in each case relating to the population of printed circuit boards (120) of a printed circuit board type (122) on the pick-and-place line (110);
- to acquire a predetermined future time period;
- to acquire probabilities, respectively associated with the jobs (220), with which the associated job (220) is to be executed in the predetermined time period;
- wherein the time period lasts at least long enough that each of the acquired jobs (220) can be processed within said time period;
- wherein frequencies of previous jobs (220), knowledge of forthcoming jobs (220) and/or jobs (220) arising in a rotation are considered in the determination of the probabilities;
- to assign printed circuit board types (122) of the jobs (220) to set-up families (210, 215);
- to determine, for each set-up family (210, 215), a characteristic number which comprises the sum of probabilities of those jobs (220), the printed circuit board types (122) of which are comprised by the set-up family (210, 215);
- to optimize assignment in such a way that the characteristic numbers of different set-up families (210, 215) are as different as possible; and
- to control the population of printed circuit boards (120) on the pick-and-place line (100), where a set-up (165, 170) from one of the determined set-up families (210, 215) is fitted on the pick-and-place line (110).

**Revendications**

1. Procédé (300) de montage de circuits imprimés (120)

- au moyen d'une chaîne de montage (110),
- des familles d'équipements (210, 215) étant prévues avec les équipements (165, 170) associés ;
- chaque famille d'équipements (210, 215) se voyant affecter au moins un type de circuit imprimé (122) et chaque équipement (165, 170) se voyant affecter au moins un type de composant (160),
- de sorte qu'un circuit imprimé (120) d'un type de circuit imprimé (122) d'une famille d'équipements (210, 215) peut être monté sur la chaîne de montage au moyen de composants (155) des types de composants (160) de l'équipement (165, 170) affecté au type de circuit imprimé (122) ;
- un équipement (165, 170) sous forme de stocks de composants (150) des types de composants (160) pouvant être réalisé pour être amené sur la chaîne de montage (110),

le procédé (300) comprenant les étapes suivantes :

- saisie de tâches (220), dans chaque cas pour monter des circuits imprimés (120) d'un type de circuit imprimé (122) sur la chaîne de montage (110) ;
- saisie d'un délai prédéterminé dans le futur ;
- saisie de la probabilité affectée à chacune des tâches (220), selon laquelle la tâche associée (220) sera exécutée dans le délai prédéterminé ;
- le délai étant suffisamment long pour que chacune des tâches (220) saisies puisse être traitée dans ce délai ;
- la détermination de la probabilité tenant compte de la fréquence des tâches (220) en retard, de la connaissance des tâches (220) à venir et/ou des tâches (220) récurrentes ;
- attribution des types de circuits imprimés (122) des tâches (220) aux familles d'équipements (210, 215) ;
- détermination, pour chaque famille d'équipements (210, 215), d'un indicateur comprenant la somme des probabilités des tâches (220) dont les types de circuits imprimés (122) sont compris dans la famille d'équipements (210, 215) ;
- optimisation de l'affectation, de manière à ce que les indicateurs des différentes familles d'équipements (210, 215) soient aussi différents que possible ;
- fourniture d'un équipement (165, 170) de l'une des familles d'équipements (210, 215) déterminées sur la chaîne de montage (110) ; et
- montage des circuits imprimés (120) sur la chaîne de montage (110).

2. Procédé (300) selon la revendication 1, dans lequel l'optimisation est effectuée de manière à minimiser le nombre de familles d'équipements (210, 215).

3. Procédé (300) selon l'une des revendications précédentes, dans lequel les familles d'équipements (210, 215) sont formées les unes après les autres et l'optimisation est effectuée dans chaque cas de manière à maximiser un nombre de tâches (220) pouvant être traitées à l'aide des équipements (165, 170) des familles d'équipements (210, 215).

4. Procédé (300) selon l'une des revendications précédentes, dans lequel les familles d'équipements (210, 215) sont formées les unes après les autres et l'optimisation est effectuée dans chaque cas de manière à ce que pour les types de circuits imprimés (122) affectés à une nouvelle famille d'équipements (210, 215), l'indicateur suivant soit minimisé : $\log(1 - p_r)$ ; $p_r$ étant la probabilité qu'une tâche (220) de montage de circuits imprimés (120) du type de circuits imprimés (122) soit égale à r.

5. Procédé (300) selon l'une des revendications précédentes, dans lequel l'optimisation est effectuée au moyen d'une optimisation en nombres entiers mixte.

6. Dispositif de commande pour le montage de circuits imprimés (120) au moyen d'une chaîne de montage (110),

- des familles d'équipements (210, 215) étant prévues avec les équipements (165, 170) associés ;
- chaque famille d'équipements (210, 215) se voyant affecter au moins un type de circuit imprimé (122) et chaque équipement (165, 170) se voyant affecter au moins un type de composant (160),
- de sorte qu'un circuit imprimé (120) d'un type de circuit imprimé (122) d'une famille d'équipements (210, 215) peut être monté sur la chaîne de montage au moyen de composants (150) des types de composants (160) de l'équipement (165, 170) affecté au type de circuit imprimé (122) ;
- un équipement (165, 170) sous forme de stocks de composants (150) des types de composants (160) pouvant être réalisé pour être amené sur la chaîne de montage (110),

le dispositif de commande (115) étant conçu pour

- saisir des tâches (220), dans chaque cas pour monter des circuits imprimés (120) d'un type de circuit imprimé (122) sur la chaîne de montage (110) ;
- saisir un délai prédéterminé dans le futur ;
- saisir la probabilité affectée à chacune des tâches (220), selon laquelle la tâche associée (220) sera exécutée dans le délai prédéterminé ;
- le délai étant suffisamment long pour que chacune des tâches (220) saisies puisse être traitée dans ce délai ;
- la détermination de la probabilité tenant compte de la fréquence des tâches (220) en retard, de la connaissance des tâches (220) à venir et/ou des tâches (220) récurrentes ;
- affecter les types de circuits imprimés (122) des tâches (220) aux familles d'équipements (210, 215) ;
- déterminer, pour chaque famille d'équipements (210, 215), un indicateur comprenant la somme des probabilités des tâches (220) dont les types de circuits imprimés (122) sont compris dans la famille d'équipements (210, 215) ;
- optimiser l'affectation, de manière à ce que les indicateurs des différentes familles d'équipements (210, 215) soient aussi différents que possible ; et
- commander le montage de circuits imprimés (120) sur la chaîne de montage (100), lorsqu'un équipement (165, 170) de l'une des familles d'équipements (210, 215) déterminées est amené sur la chaîne de montage (110).

# FIG 1

FIG 2

FIG 3A

FIG 3B

FIG 4A

FIG 4B

## FIG 5B

## FIG 5B

# FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012220904 A1
- EP 0478360 A1

- DE 69028612 T2
- DE 102012220904